# EUROPEAN PATENT APPLICATION

(11) **EP 2 562 288 A2**
(43) Date of publication of application: **27.02.2013**
(21) Application number: 12753370.1
(22) Date of filing: 22.05.2012
(51) Int. Cl.: C23C 14/24

(54) **VACUUM DEPOSITION APPARATUS**

(30) Priority: 31.05.2011 KR 20110052455
(71) Applicant: SNU Precision Co., Ltd., Seoul 152-818 (KR)
(72) Inventor: KONG, Doo Won, Seoul 158-849 (KR); LEE, Jong Ha, Gyeonggi-do 445-987 (KR); JUNG, Sung Jea, Gyeonggi-do 463-928 (KR); PARK, Sang Hyun, Chungcheongnam-do 336-719 (KR)
(74) Representative: Levlin, Jan Markus
(86) International application number: PCT/KR2012/004025
(87) International publication number: WO 2012/165792

(57) **Abstract**

Disclosed is a vacuum deposition apparatus for depositing a source on a substrate arranged in a vacuum chamber, the vacuum deposition apparatus including: a substrate carrier which carries the substrate; a nozzle which is arranged to be opposite to the substrate carrier and jets a source to the substrate arranged on the substrate carrier; and a temperature controller which controls a surface temperature of the substrate carrier so that the source can be prevented from being deposited on the substrate carrier.

With this, there is provided a vacuum deposition apparatus which can minimizes deterioration in productivity caused when sources deposited as particles on the substrate carrier for carrying a substrate.

## Description

### CROSS-REFERENCE TO RELATED APPLICATION

This application claims priority to and the benefit of Korean Patent Application No. 10-2011-0052455 filed in the Korean Intellectual Property Office on May 31, 2011, the entire contents of which are incorporated herein by reference.

### BACKGROUND OF THE INVENTION

### (a) Field of the Invention

The present invention relates to a vacuum deposition apparatus, and more particularly, to a vacuum deposition apparatus with a substrate carrier on which source deposition is prevented, thereby improving productivity.

### (b) Description of the Related Art

In manufacturing a display or a solar cell, a vacuum deposition apparatus has been used as a physical deposition method for forming a thin film on a substrate. Such a vacuum deposition apparatus forms a thin film by solidifying atoms or molecules of a deposition material on an objective surface in a vacuum chamber through a physical or chemical method.

Meanwhile, an in-line process will be promoted and a large-sized will be processed by a method jetting the deposition material on the substrate successively carried by a transfer roller.

However, such a conventional vacuum deposition apparatus has a problem that the deposition materials to be jetted as particles from a nozzle are deposited on not only the substrate but also an area extended up to the transfer roller for in-line carry of the substrate because the deposition materials are jetted toward the substrate without exactly specifying a target area.

The particles of the deposition material deposited at an undesired position contaminate the transfer roller, thereby shortening the lifespan of the transfer roller and deteriorating productivity and efficiency.

### SUMMARY OF THE INVENTION

Accordingly, the present invention is conceived to solve the forgoing problems, and an aspect of the present invention is to provide a vacuum deposition apparatus which can minimizes deterioration in productivity caused when sources deposited as particles on a substrate carrier for carrying a substrate.

One aspect of the present invention provides a vacuum deposition apparatus for depositing a source on a substrate arranged in a vacuum chamber, the vacuum deposition apparatus including: a substrate carrier which carries the substrate; a nozzle which is arranged to be opposite to the substrate carrier and jets a source to the substrate arranged on the substrate carrier; and a temperature controller which controls a surface temperature of the substrate carrier so that the source can be prevented from being deposited on the substrate carrier.

The temperature controller may control the surface temperature of the substrate carrier by injecting heated fluid into an inside of the substrate carrier.

The temperature controller may include an oil feeder which is provided outside the chamber and storing the heated oil; and a connecting pipe which connects the oil feeder and an end of the substrate carrier and circulates the oil.

The substrate carrier may include a transfer roller internally formed with an oil flowing channel in which the oil flows, and long provided along a width direction of the substrate, and the connecting pipe may include an injection pipe connecting one end of the oil flowing channel with the oil feeder so that the oil can be injected into the oil flowing channel; and a withdrawal pipe connecting the other end of the oil flowing channel with the oil feeder so that the oil can be withdrawn from the oil flowing channel.

The substrate carrier may include a pair of transfer rollers arranged opposite to each other and carrying the substrate while contacting and supporting opposite ends of the substrate, each transfer roller including an oil injection hole and an oil withdrawal hole communicating with the oil injection hole, and the connecting pipe may include an injection pipe connecting the oil feeder with the oil injection hole of each transfer roller; and a withdrawal pipe connecting the oil feeder with the oil withdrawal hole of each transfer roller.

The transfer roller may internally include a first oil flowing channel extended from the oil injection hole and allowing the supplied oil to flow toward the inside of the chamber; and a second oil flowing channel communicating with the first oil flowing channel while surrounding the first oil flowing channel, and allowing the oil from the first oil flowing channel to flow toward the oil withdrawal hole.

### BRIEF DESCRIPTION OF THE DRAWINGS

The above and/or other aspects of the present invention will become apparent and more readily appreciated from the following description of the exemplary embodiments, taken in conjunction with the accompanying drawings, in which:
Fig. 1 is a cross-section view of a vacuum deposition apparatus according to a first exemplary embodiment,
Fig. 2 is a cross-section view of the vacuum deposition apparatus of Fig. 1, taken along line II-II',
Fig. 3 is a cross-section view of a vacuum deposition apparatus according to a second exemplary embodiment, and
Fig. 4 is a cross-section view of the vacuum deposition apparatus of Fig. 2, taken along line IV-IV'.

### DETAILED DESCRIPTION OF THE EMBODIMENTS

Prior to description, like numerals will refer to like elements through many exemplary embodiments, which are representatively described in an exemplary embodiment, and the other exemplary embodiments describe only different configurations.

Hereinafter, a vacuum deposition apparatus 100 according to a first exemplary embodiment will be described in detail with reference to accompanying drawings.

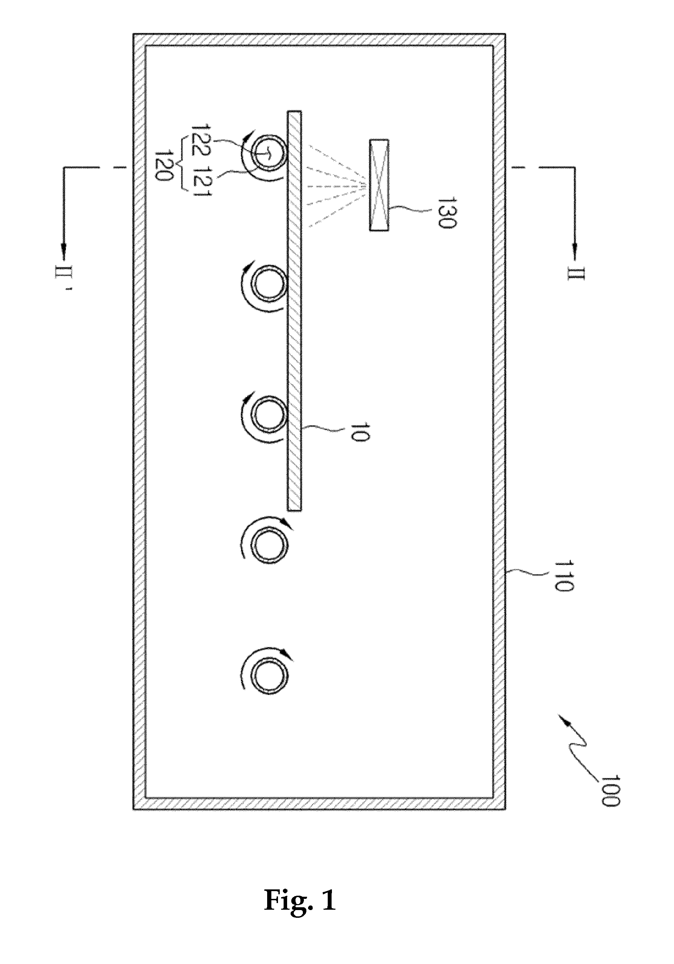

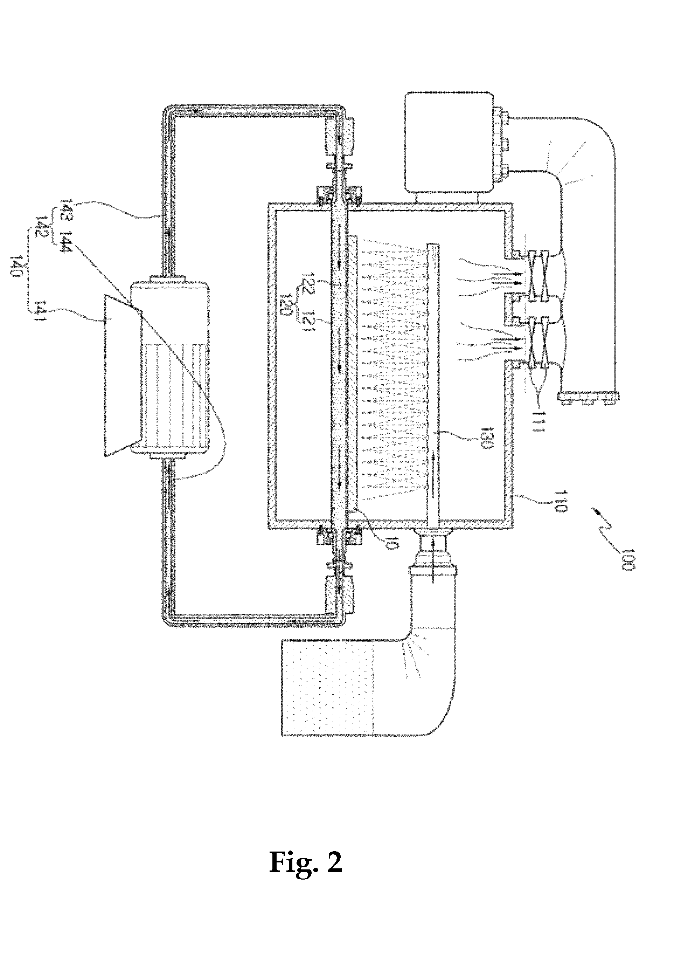

Fig. 1 is a cross-section view of a vacuum deposition apparatus according to a first exemplary embodiment, and Fig. 2 is a cross-section view of the vacuum deposition apparatus of Fig. 1, taken along line II-II'.

Referring to Figs. 1 and 2, the vacuum deposition apparatus 100 according to the first exemplary embodiment includes a chamber 110, a substrate carrier 120, a nozzle 130 and a temperature controller 140.

The chamber 110 is a member for accommodating an objective substrate 10 on to which sources jet from the nozzle 120 to be described later are deposited. The chamber 110 is configured to control inner pressure thereof, and internally provided with the substrate carrier 120 for carrying the substrate 10 at deposition process.

The chamber 110 is provided with a predetermined vacuum pump (not shown) that generates difference in pressure from the exterior and allows gasified sources to be deposited from the nozzle 130 to the substrate 10 of a lower side, thereby keeping the inside of the chamber 110 vacuum.

Also, the chamber 110 may be provided with a cold trap 111 at an upper side. The cold trap 111 is connected to a predetermined storage unit and inhales gaseous sources not used in deposition for the substrate 10.

According to this exemplary embodiment, one chamber 110 in which a deposition process is performed is illustrated, but not limited thereto. Alternatively, a plurality of chambers 110 is successively connected so that the size of the substrate 10 to be processed can be increased.

The substrate carrier 120 is a member accommodated in the chamber 110 and successively carrying the substrate, which includes a plurality of transfer roller 121.

The transfer roller 121 is extended from one side to the other side on an inner wall of the chamber 110 and provided lengthwise along a width direction of the substrate 10. The plurality of transfer rollers 121 are spaced part from each other and provided along the carrying direction of the substrate 10.

The transfer roller 121 is internally provided with an oil flowing channel 122 as a channel through which oil supplied for adjusting a surface temperature flows. The oil flowing channel 122 is formed lengthwise penetrating the transfer roller 121 from one end to the other end. The diameter of the oil flowing channel 122 is determined in consideration of injected oil, the temperature of the chamber 110, the area and weight of the substrate 10, etc. since it is associated with the durability of the transfer roller 121.

The nozzle 130 receives the sources from the exterior and jets gaseous source to be deposited on the substrate 10 of the lower side.

The temperature controller 140 circulates oil to be injected into the transfer roller 121 and controls the surface temperature. The temperature controller 140 includes an oil feeder 141, a connecting pipe 142, a heating member (not shown) and a forcible circulator (not shown).

The oil feeder 141 stores and injects heated oil into the transfer roller 121, or withdraws the oil from the transfer roller 121. Thus, the oil feeder 141 serves as a storage for storing and supplying the oil to be circulated.

The connecting pipe 142 is a passage for connecting the transfer roller 121 and the oil feeder 141, which includes an injection pipe 143 and a withdrawal pipe 144.

The injection pipe 143 is provided for injecting the oil stored in the oil feeder 141 into the transfer roller 121, which is shaped like a tube for connecting one end of the oil flowing channel 122 of the transfer roller 121 with the oil feeder 141.

The withdrawal pipe 144 is provided for collecting the oil, which is introduced into one end of the transfer roller 121, circulates in the oil flowing channel 122, and is discharged from the other end of the transfer roller 121, into the oil feeder 141. The withdrawal pipe 144 is shaped like a tube for connecting the oil feeder 141 with the oil flowing channel 122 at an opposite end to which the injection pipe 143 is connected.

The heating member (not shown) is mounted to the oil feeder 141, and heats the oil so that the temporarily stored oil can keep temperature proper to be injected into the oil flowing channel 122.

The forcible circulator (not shown) provides forcible pressure so that the oil can repetitively circulate via the oil feeder 141, the injection pipe 143, the oil flowing channel 122 and the withdrawal pipe 144. The forcible circulator may be achieved by a predetermined pump that receives electric power and generates difference in pressure.

Meanwhile, the oil circulating from the oil feeder 141 to the transfer roller 121 may include oil having an evaporation point which is so high that the oil can circulate in a liquid state without being evaporated at a temperature of injection into the transfer roller 121.

Now, operation of the vacuum deposition apparatus 100 according to the first exemplary embodiment will be described.

Referring to Fig. 2, if the substrate 10 is carried by the transfer roller 121 within the chamber 110 of the vacuum state, a gaseous source is supplied from a predetermined exterior feeder into the nozzle 130 and the supplied gaseous source is jetted from the nozzle 130 toward the substrate 10.

The source from the nozzle 130 is jetted without having exact directionality, and therefore it may be partially jetted to an unintended area within the chamber 110 as well as the objective substrate 10, and particularly deposited on the transfer roller 121, thereby contaminating the transfer roller 121.

At this time, together with the source jetted from the nozzle 130, the heated oil from the oil feeder 141 is injected into the oil flowing channel 122 formed in the transfer roller 121 via the injection pipe 143 by the forcible circulator.

As the injected oil of high temperature flows in the oil flowing channel 122, it exchanges heat with the surface of the transfer roller 121, so that the surface of the transfer roller 121 can keep high temperature. Due to the high temperature of the surface, the gaseous source applied to the surface of the transfer roller 121 does not become particles and maintains a gaseous state.

Such a source of the gaseous state is inhaled and stored in the predetermined storage through the cold trap 111, and thus prevented from being deposited on an undesired position in the chamber 110.

The oil flowing in the oil flowing channel 122 and exchanging heat with the surface of the transfer roller 121 is discharged from the transfer roller 121 while having a relatively lowered temperature, and collected in the oil feeder 141 through the withdrawal pipe 144. At this time, the oil feeder 141 includes a predetermined heating member (not shown) so that the oil can be heated at a required temperature when it is supplied again to the transfer roller 121.

Next, a vacuum deposition apparatus 200 according to a second exemplary embodiment will be described.

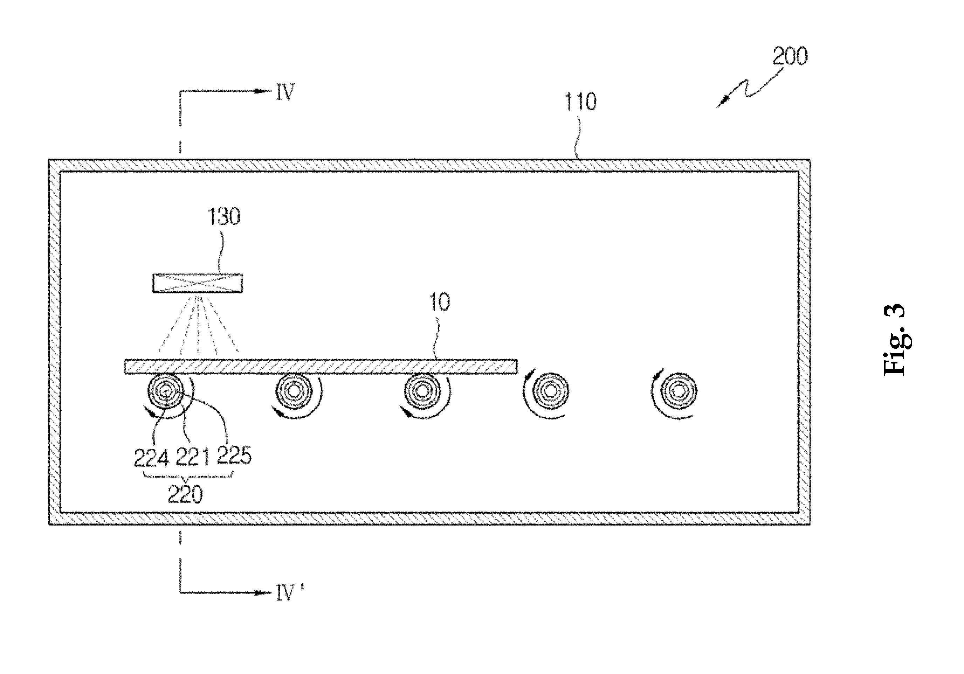

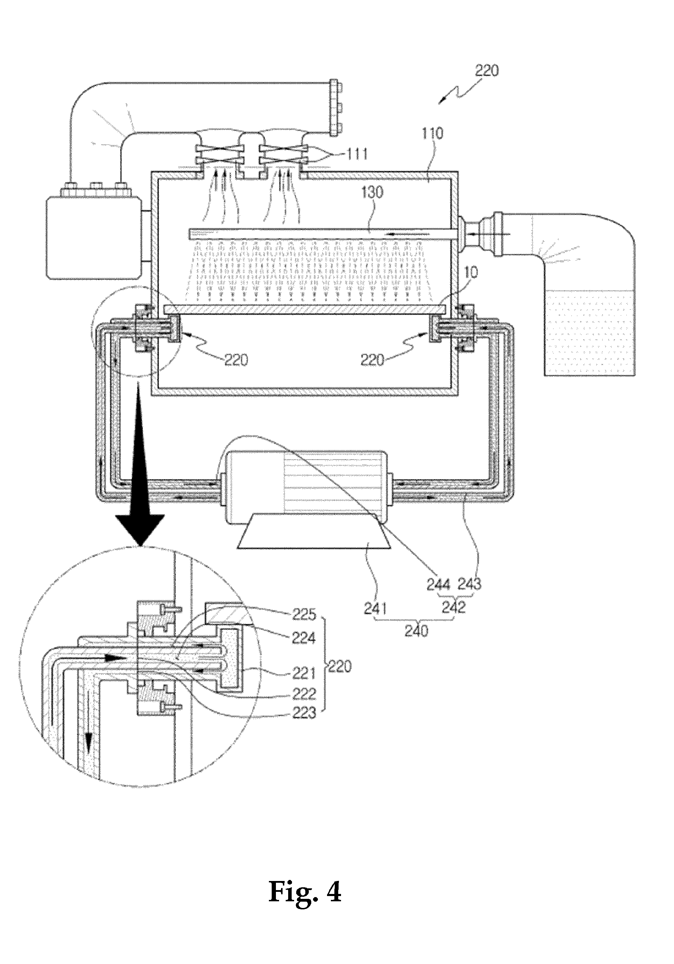

Fig. 3 is a cross-section view of a vacuum deposition apparatus according to a second exemplary embodiment, and Fig. 4 is a cross-section view of the vacuum deposition apparatus of Fig. 2, taken along line IV-IV'.

Referring to Figs. 3 and 4, the vacuum deposition apparatus 200 according to the second exemplary embodiment includes a chamber 110, a substrate carrier 220, a nozzle 130, and a temperature controller 240. The chamber 110 and the nozzle 130 are the same as those according to the first exemplary embodiment, and thus repetitive descriptions thereof will be avoided.

The substrate carrier 120 according to the first exemplary embodiment is configured to support the entire surface of the substrate 10 along the width direction because the single transfer roller 121 is provided lengthwise in the width direction of the substrate 10. On the contrary to the substrate carrier 120, the substrate carrier 220 according to the second exemplary embodiment includes a pair of transfer rollers 221 spaced apart from each other to support only opposite sides of the substrate 10. The pair of transfer rollers 221 are arranged to oppose to each other.

In this exemplary embodiment, the transfer roller 221 is mounted so that one end of the transfer roller 221 faces toward the inside of the chamber 110 and the other end is exposed to the outside of the chamber 110. The end of the transfer roller 221 exposed to the outside of the chamber 110 is formed with an oil injection hole 222 through which the oil is injected, and an oil withdrawal hole 223 through which the injected oil is withdrawn.

Also, the inside of each transfer roller 221 is formed with a first oil flowing channel 224 communicating with the oil injection hole 222 and a second oil flowing channel 225 communicating with the oil withdrawal hole 223 so that the oil introduced from the oil injection hole 222 can flow.

The first oil flowing channel 224 is formed at the center of the transfer roller 221 generally having a cylindrical shape, and the second oil flowing channel 225 is formed concentrically with the first oil flowing channel 224 while surrounding the first oil flowing channel 224. That is, the oil injection hole 222 is formed on the surface of the transfer roller 221 exposed to the outside of the chamber, and the first oil flowing channel 224 communicating with the oil injection hole 222 is formed along the lengthwise direction of the transfer roller 221. Further, the second oil flowing channel 225 communicating with the oil withdrawal hole 223 and having one end connected to the first oil flowing channel 224 and the other end formed on the surface on which the oil injection hole 222 of the transfer roller 221 is formed is formed inside the transfer roller 221 while surrounding the first oil flowing channel 224 concentrically with the first oil flowing channel 224.

The temperature controller 240 is to control the surface temperature of the transfer roller 221 by supplying the oil to the inside of the transfer roller 221. The temperature controller 240 includes an oil feeder 241 and a connecting pipe 242.

The oil feeder 241 is the same as that described in the first exemplary embodiment, and thus repetitive description thereof will be avoided.

The connecting pipe 242 includes an injection pipe 243 and a withdrawal pipe 244.

The injection pipe 243 connects the oil feeder 241 with the oil injection hole 222 formed in each transfer roller 221, and the withdrawal pipe 244 connects the oil feeder 241 with the oil withdrawal hole 223 formed one of the transfer rollers 221. That is, according to this exemplary embodiment, every transfer roller 221 includes the injection pipe 243 and the withdrawal pipe 244. Thus, the pair of opposite transfer rollers 221 totally includes a pair of injection pipes 243 and a pair of withdrawal pipes 244.

Now, operation of the vacuum deposition apparatus 200 according to the second exemplary embodiment will be described.

If the substrate 10 is carried by the substrate carrier 220 within the chamber 110 of the vacuum state, a gaseous source is supplied from a predetermined exterior feeder into the nozzle 130 and the supplied gaseous source is jetted from the nozzle 130 toward the substrate 10.

The source from the nozzle 130 is jetted without having exact directionality, and therefore it may be partially jetted to an unintended area within the chamber 110 as well as the objective substrate 10, and particularly deposited on the transfer roller 121, thereby contaminating the transfer roller 121.

At this time, together with the source jetted from the nozzle 130, the heated oil from the oil feeder 141 is injected into the first oil flowing channel 224 formed in the transfer roller 221 via the injection pipe 243. The heated oil flows toward the inside of the chamber within the first oil flowing channel 224 and transfers heat to the surface of the transfer roller 221 and the oil flowing in the second oil flowing channel 224 through a partition wall, so that the surface of the transfer roller 221 can maintain high temperature. Due to the high temperature of the surface, the gaseous source applied to the surface of the transfer roller 221 is prevented from becoming particle and being deposited on the substrate 10.

Such a source of the gaseous state is inhaled and stored in the predetermined storage through the cold trap 111, and thus prevented from being deposited on an undesired position in the chamber 110.

The oil at the end of the first oil flowing channel 224 is introduced into the second oil flowing channel 225 communicating with the first oil flowing channel 224, and heats the surface of the transfer roller 221 again while receiving some heat through the partition wall from the oil flowing in the second oil flowing channel 225 and the first oil flowing channel 224.

The oil that completes flowing in the second oil flowing channel 225 is discharged to the outside of the transfer roller 221 via the oil withdrawal hole 222, and stored in the oil feeder 241 through the connected withdrawal pipe 244. At this time, the oil feeder 241 includes a predetermined heating member (not shown) so that the oil can be heated at a required temperature when it is supplied again to the transfer roller 221.

The vacuum deposition apparatus 200 according to the present exemplary embodiment has a structure of supplying the oil to the respective transfer rollers 221 and collecting it again, so that the surface temperature of each transfer roller 221 can be individually controlled.

Also, the structural characteristic of the transfer roller 221 causes a relatively short section where the oil flows and exchanges heat with the surface of the transfer roller 221, and minimizes difference in temperature between the injected oil and the withdrawal oil, thereby minimizing consumption of energy needed for controlling the temperature of the transfer roller.

Further, the oil flowing in the first oil flowing channel 224 and the oil flowing in the second oil flowing channel 225, flowing directions of which are opposite to each other, repetitively heat the surface of the transfer roller 221, thereby achieving excellent heating performance.

According to an exemplary embodiment, there is provided a vacuum deposition apparatus which controls a surface temperature of a substrate carrier, thereby preventing sources from becoming particles and being deposited on the substrate carrier.

According to an exemplary embodiment, there is provided a vacuum deposition apparatus in which a surface temperature of a substrate carrier is controlled to thereby prevent sources from being deposited as particles on the substrate carrier.

Also, oil is circulated between the substrate carrier and an oil feeder to thereby control the surface temperature of the substrate carrier.

Further, the substrate carrier includes a pair of separated transfer rollers to thereby minimize length and a heat transfer area and thus minimize consumption of energy for controlling the surface temperature.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A vacuum deposition apparatus for depositing a source on a substrate arranged in a vacuum chamber, the vacuum deposition apparatus comprising:
a substrate carrier which carries the substrate;
a nozzle which is arranged to be opposite to the substrate carrier and jets a source to the substrate arranged on the substrate carrier; and
a temperature controller which controls a surface temperature of the substrate carrier so that the source can be prevented from being deposited on the substrate carrier.

2. The vacuum deposition apparatus according to claim 1, wherein the temperature controller controls the surface temperature of the substrate carrier by injecting heated fluid into an inside of the substrate carrier.

3. The vacuum deposition apparatus according to claim 2, wherein the temperature controller comprises:
an oil feeder which is provided outside the chamber and storing the heated oil; and
a connecting pipe which connects the oil feeder and an end of the substrate carrier and circulates the oil.

4. The vacuum deposition apparatus according to claim 3, wherein
the substrate carrier comprises a transfer roller internally formed with an oil flowing channel in which the oil flows, and long provided along a width direction of the substrate, and
the connecting pipe comprises an injection pipe connecting one end of the oil flowing channel with the oil feeder so that the oil can be injected into the oil flowing channel; and a withdrawal pipe connecting the other end of the oil flowing channel with the oil feeder so that the oil can be withdrawn from the oil flowing channel.

5. The vacuum deposition apparatus according to claim 3, wherein
the substrate carrier comprises a pair of transfer rollers arranged opposite to each other and carrying the substrate while contacting and supporting opposite ends of the substrate, each transfer roller comprising an oil injection hole and an oil withdrawal hole communicating with the oil injection hole, and
the connecting pipe comprises an injection pipe connecting the oil feeder with the oil injection hole of each transfer roller; and a withdrawal pipe connecting the oil feeder with the oil withdrawal hole of each transfer roller.

6. The vacuum deposition apparatus according to claim 5, wherein the transfer roller internally comprises a first oil flowing channel extended from the oil injection hole and allowing the supplied oil to flow toward the inside of the chamber; and a second oil flowing channel communicating with the first oil flowing channel while surrounding the first oil flowing channel, and allowing the oil from the first oil flowing channel to flow toward the oil withdrawal hole.
